(19) **Europäisches Patentamt**
**European Patent Office**
**Office européen des brevets**

(11) **EP 3 660 744 A1**

(12) **EUROPEAN PATENT APPLICATION**

(43) Date of publication:
**03.06.2020  Bulletin 2020/23**

(51) Int Cl.:
**G06N 3/04** (2006.01)       **G06N 3/08** (2006.01)
**G03F 1/36** (2012.01)       **G03F 7/20** (2006.01)

(21) Application number: **18209496.1**

(22) Date of filing: **30.11.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **MIDDLEBROOKS, Scott, Anderson**
  **5500 AH Veldhoven (NL)**

• **VAN KRAAIJ, Markus, Gerardus, Martinus, Maria**
  **5500 AH Veldhoven (NL)**
• **PISARENCO, Maxim**
  **5500 AH Veldhoven (NL)**

(74) Representative: **Peters, John Antoine**
**ASML Netherlands BV**
**Corporate Intellectual Property**
**De Run 6501**
**P.O. Box 324**
**5500 AH Veldhoven (NL)**

(54) **METHOD FOR DECREASING UNCERTAINTY IN MACHINE LEARNING MODEL PREDICTIONS**

(57)      Described herein is a method for quantifying uncertainty in parameterized (e.g., machine learning) model predictions. The method comprising causing a machine learning model to predict multiple output realizations from the machine learning model for a given input; determining a variability of the predicted multiple output realizations for the given input, and using the determined variability in the predicted multiple output realizations to adjust the machine learning model to decrease an uncertainty of the machine learning model. The machine learning model comprises encoder-decoder architecture. The method comprises using the determined variability in the predicted multiple output realizations to adjust the machine learning model to decrease the uncertainty of the machine learning model for predicting wafer geometry, overlay, and/or other information as part of a semiconductor manufacturing process.

FIG. 6

EP 3 660 744 A1

**Description**

TECHNICAL FIELD

The description herein relates generally to mask manufacturing and patterning processes. More particularly, the description relates to an apparatus and a method for determining and/or decreasing uncertainty in parameterized (e.g., machine learning) model predictions.

BACKGROUND

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices as described herein can be gleaned, for example, from US 6,046,792, incorporated herein by reference.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc. One or more metrology processes are typically involved in the patterning process.

As noted, lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced while the amount of functional elements, such as transistors, per device has been steadily increasing over decades, following a trend commonly referred to as "Moore's law". At the current state of technology, layers of devices are manufactured using lithographic projection apparatuses that project a design layout onto a substrate using illumination from a deep-ultraviolet illumination source, creating individual functional elements having dimensions well below 100 nm, i.e. less than half the wavelength of the radiation from the illumination source (e.g., a 193 nm illumination source).

This process in which features with dimensions smaller than the classical resolution limit of a lithographic projection apparatus are printed, is commonly known as low-ki lithography, according to the resolution formula CD =

$k_1 \times \lambda / NA$, where $\lambda$ is the wavelength of radiation employed (currently in most cases 248nm or 193nm), NA is the numerical aperture of projection optics in the lithographic projection apparatus, CD is the "critical dimension"-generally the smallest feature size printed-and $k_1$ is an empirical resolution factor. In general, the smaller $k_1$ the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET). The term "projection optics" as used herein should be broadly interpreted as encompassing various types of optical systems, including refractive optics, reflective optics, apertures and catadioptric optics, for example. The term "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.

## SUMMARY

According to an embodiment, there is provided a method for quantifying uncertainty in machine learning (or any other parameterized) model predictions. The method comprises causing a machine learning model to predict multiple outputs from the machine learning model for a given input. The method comprises determining a variability of the predicted multiple output realizations for the given input, and using the determined variability in the predicted multiple output realizations to quantify uncertainty in the predicted multiple output realizations from the machine learning model.

The method comprises using the determined variability in the predicted multiple output realizations and/or the quantified uncertainty to adjust the machine learning model to decrease the uncertainty of the machine learning model by either making the machine learning model more descriptive or including more diverse training data.

In an embodiment, the machine learning model comprises encoder-decoder architecture.

In an embodiment, the method further comprises training a variational encoder-decoder architecture with sampling from a latent space, which decodes into an output space. In an embodiment, the latent space comprises a low dimensional encoding.

In an embodiment, the method further comprises determining, for the given input, a conditional probability $p(z|x)$ of a latent variable with an encoder of the encoder-decoder architecture. In an embodiment, the method further comprises determining a conditional probability $p(x'|z)$ with a decoder of the encoder-decoder architecture.

In an embodiment, the method further comprises sampling from the conditional probability $p(z|x)$, and for each sample, predicting an output of the predicted multiple output realizations using the decoder of the encoder-decoder architecture. In an embodiment, the method further comprises determining the variability of the predicted multiple output realizations for the given input based on the predicted output for each sample.

In an embodiment, the conditional probability $p(z|x)$ is determined by the encoder using variational inference techniques. In an embodiment, the variational inference techniques comprise identifying an approximation to $p(z|x)$ in a parametric family of distributions $q_\theta(z|x)$, where $\theta$ are parameters of the family. In some embodiments, a parametric family of distributions comprises any parameterized distribution. Family may refer to a type or shape of the distribution, or combinations of distributions, for example.

In an embodiment, the method further comprises determining a first posterior distribution $q_\theta(z|x)$, wherein a distance of the first posterior distribution to an origin of the latent space is inversely proportional to the uncertainty of the machine learning model. In an embodiment, the method further comprises determining a second posterior distribution $p_\phi(x'|q_\theta(z|x))$, wherein a variance of the second posterior distribution is directly related to the uncertainty of the machine learning model.

In an embodiment, the uncertainty of the machine learning model is related to an uncertainty of weights of parameters of the machine learning model, and a size and descriptiveness of the latent space. In an embodiment, using the determined variability in the predicted multiple output realizations to adjust the machine learning model to decrease the uncertainty of the machine learning model comprises increasing a training set size and/or adding to a dimensionality of the latent space. In an embodiment, using the determined variability in the predicted multiple output realizations to adjust the machine learning model to decrease the uncertainty of the machine learning model comprises adding additional dimensionality to the latent space. In an embodiment, using the determined variability in the predicted multiple output realizations to adjust the machine learning model to decrease the uncertainty of the machine learning model comprises training the machine learning model with additional and more diverse sampling from the latent space relative to prior sampling from the latent space.

In an embodiment, the method further comprises using the determined variability in the predicted multiple output realizations to adjust the machine learning model to decrease the uncertainty of the machine learning model for predicting mask geometry in a semiconductor manufacturing process. In an embodiment, the method further comprises using the determined variability in the predicted multiple output realizations to adjust the machine learning model to decrease the uncertainty of the machine learning model for predicting wafer geometry as part of a semiconductor manufacturing process.

In an embodiment, the method further comprises using the determined variability in the predicted multiple output realizations to adjust the machine learning model to decrease the uncertainty of the machine learning model for generating a predicted overlay as part of a semiconductor manufacturing process.

According to another embodiment, there is provided a computer program product comprising a non-transitory computer readable medium having instructions recorded thereon, the instructions when executed by a computer implementing the method described above.

## BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Fig. 1 shows a block diagram of various subsystems of a lithography system, according to an embodiment.

Fig. 2 illustrates an exemplary flow chart for simulating lithography in a lithographic projection apparatus, according to an embodiment.

Fig. 3 illustrates a summary of operations of a present method for decreasing uncertainty in machine learning model predictions, according to an embodiment.

Fig. 4 illustrates a convolutional encoder-decoder, according to an embodiment.

Fig. 5 illustrates encoder-decoder architecture within a neural network, according to an embodiment.

Fig. 6 illustrates a variational encoder-decoder architecture version of Fig. 5, with sampling in a latent space, according to an embodiment.

Fig. 7 illustrates a mask image used as input for a machine learning model, a mean of the predicted outputs from the machine learning model predicted based on the mask image, an image that illustrates variance in the predicted outputs, a scanning electron microscope (SEM) image of an actual mask produced using the mask image, and a latent space illustrating a posterior distribution, in accordance with an embodiment.

Fig. 8 illustrates a second mask image used as input for the machine learning model, a second mean of the predicted outputs from the machine learning model predicted based on the second mask image, a second image that illustrates variance in the predicted outputs, a second SEM image of an actual mask produced using the second mask image, and a second latent space illustrating a second posterior distribution, in accordance with an embodiment.

Fig. 9 illustrates a third mask image used as input for the machine learning model, a third mean of the predicted outputs from the machine learning model predicted based on the third mask image, a third image that illustrates variance in the predicted outputs, a third SEM image of an actual mask produced using the third mask image, and a third latent space illustrating a third posterior distribution, in accordance with an embodiment.

Fig. 10 is a block diagram of an example computer system, according to an embodiment.

Fig. 11 is a schematic diagram of a lithographic projection apparatus, according to an embodiment.

Fig. 12 is a schematic diagram of another lithographic projection apparatus, according to an embodiment.

Fig. 13 is a more detailed view of the apparatus in Fig. 12, according to an embodiment.

Fig. 14 is a more detailed view of the source collector module SO of the apparatus of Fig. 12 and Fig. 13, according to an embodiment.

## DETAILED DESCRIPTION

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the method described herein may have many other possible applications in diverse fields such as language processing systems, self-driving cars, medical imaging and diagnosis, semantic segmentation, denoising, chip design, electronic design automation, etc. The present method may be applied in any fields where quantifying uncertainty in machine learning model predictions is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means. Examples of other such patterning devices also include a programmable LCD array. An example of such a construction is given in U.S. Patent No. 5,229,872, which is incorporated herein by reference.

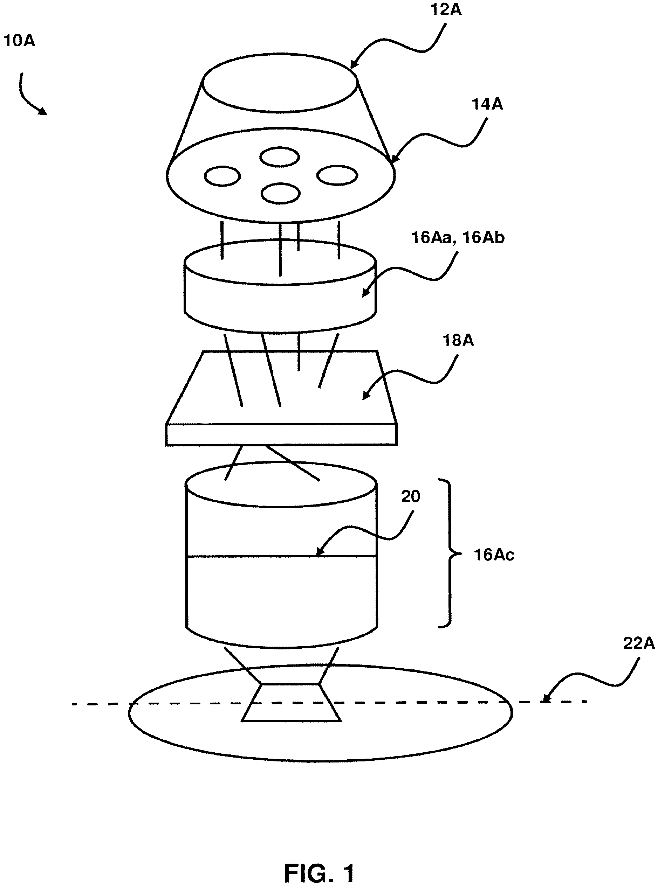

As a brief introduction, Fig. 1 illustrates an exemplary lithographic projection apparatus 10A. Major components are a radiation source 12A, which may be a deep-ultraviolet (DUV) excimer laser source or other type of source including an extreme ultra violet (EUV) source (as discussed above, the lithographic projection apparatus itself need not have the radiation source), illumination optics which, for example, define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics $NA = n \sin(\Theta_{max})$, wherein n is the refractive index of the media between the substrate and the last element of the projection optics, and $\Theta_{max}$ is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image, an example of which can be found in U.S. Patent Application Publication No. US 2009-0157630, the disclosure of which is hereby incorporated by reference in its entirety. The resist model is related only to properties of the resist layer (e.g., effects of chemical processes that occur during exposure, post-exposure bake (PEB) and development). Optical properties of the lithographic projection apparatus (e.g., properties of the illumination, the patterning device and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251, the disclosure of each being hereby incorporated by reference in its entirety.

It is often desirable to be able computationally determine how a patterning process would produce a desired pattern on a substrate. Thus, simulations may be provided to simulate one or more parts of the process. For example, it is desirable to be able to simulate the lithography process of transferring the patterning device pattern onto a resist layer of a substrate as well as the yielded pattern in that resist layer after development of the resist.

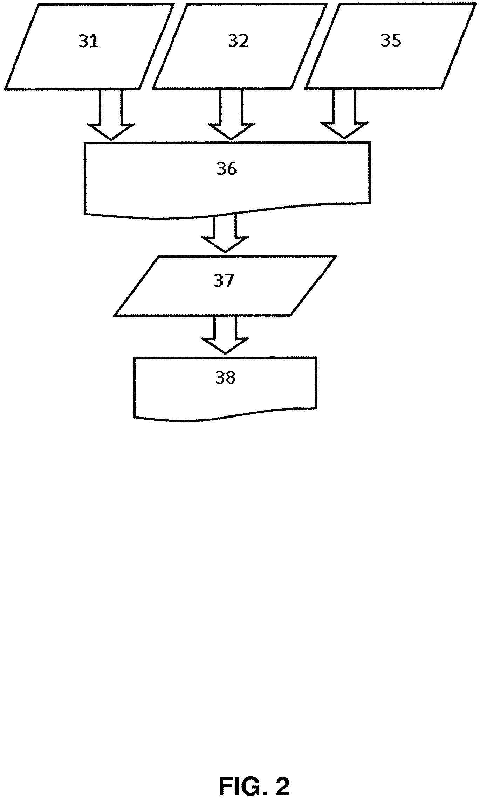

An exemplary flow chart for simulating lithography in a lithographic projection apparatus is illustrated in Fig. 2. An illumination model 31 represents optical characteristics (including radiation intensity distribution and/or phase distribution) of the illumination. A projection optics model 32 represents optical characteristics (including changes to the radiation intensity distribution and/or the phase distribution caused by the projection optics) of the projection optics. A design layout model 35 represents optical characteristics (including changes to the radiation intensity distribution and/or the phase distribution caused by a given design layout) of a design layout, which is the representation of an arrangement of features on or formed by a patterning device. An aerial image 36 can be simulated using the illumination model 31, the projection optics model 32, and the design layout model 35. A resist image 38 can be simulated from the aerial image 36 using a resist model 37. Simulation of lithography can, for example, predict contours and/or CDs in the resist image.

More specifically, illumination model 31 can represent the optical characteristics of the illumination that include, but are not limited to, NA-sigma ($\sigma$) settings as well as any particular illumination shape (e.g. off-axis illumination such as annular, quadrupole, dipole, etc.). The projection optics model 32 can represent the optical characteristics of the of the projection optics, including, for example, aberration, distortion, a refractive index, a physical size or dimension, etc. The design layout model 35 can also represent one or more physical properties of a physical patterning device, as described, for example, in U.S. Patent No. 7,587,704, which is incorporated by reference in its entirety. Optical properties associated with the lithographic projection apparatus (e.g., properties of the illumination, the patterning device and the projection optics) dictate the aerial image. Since the patterning device used in the lithographic projection apparatus can be changed, it is desirable to separate the optical properties of the patterning device from the optical properties of the rest of the lithographic projection apparatus including at least the illumination and the projection optics (hence design layout model 35).

The resist model 37 can be used to calculate the resist image from the aerial image, an example of which can be found in U.S. Patent No. 8,200,468, which is hereby incorporated by reference in its entirety. The resist model is typically related to properties of the resist layer (e.g., effects of chemical processes which occur during exposure, post-exposure bake and/or development).

The objective of the simulation is to accurately predict, for example, edge placements, aerial image intensity slopes and/or CDs, which can then be compared against an intended design. The intended design is generally defined as a pre-OPC design layout which can be provided in a standardized digital file format such as GDSII, OASIS or other file format.

From the design layout, one or more portions may be identified, which are referred to as "clips". In an embodiment, a set of clips is extracted, which represents the complicated patterns in the design layout (typically about 50 to 1000 clips, although any number of clips may be used). As will be appreciated by those skilled in the art, these patterns or clips represent small portions (e.g., circuits, cells, etc.) of the design and especially the clips represent small portions for which particular attention and/or verification is needed. In other words, clips may be the portions of the design layout or may be similar or have a similar behavior of portions of the design layout where critical features are identified either by experience (including clips provided by a customer), by trial and error, or by running a full-chip simulation. Clips often contain one or more test patterns or gauge patterns. An initial larger set of clips may be provided a priori by a customer based on known critical feature areas in a design layout which require particular image optimization. Alternatively, in another embodiment, the initial larger set of clips may be extracted from the entire design layout by using some kind of automated (such as, machine vision) or manual algorithm that identifies the critical feature areas.

In some examples, the simulation and modeling can be used to configure one or more features of the patterning device pattern (e.g., performing optical proximity correction), one or more features of the illumination (e.g., changing one or more characteristics of a spatial / angular intensity distribution of the illumination, such as change a shape), and/or one or more features of the projection optics (e.g., numerical aperture, etc.). Such configuration can be generally referred to as, respectively, mask optimization, source optimization, and projection optimization. Such optimization can be performed on their own, or combined in different combinations. One such example is source-mask optimization (SMO), which involves the configuring of one or more features of the patterning device pattern together with one or more features of the illumination. The optimization techniques may focus on one or more of the clips. The optimizations may use the machine learning model described herein to predict values of various parameters (including images, etc.).

In some embodiments, an optimization process of a system may be represented as a cost function. The optimization process may comprise finding a set of parameters (design variables) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system. The design variables of the system can be confined to finite ranges and/or be interdependent due to practicalities of implementations of the system. In the case of a lithographic projection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus.

In some embodiments, illumination model 31, projection optics model 32, design layout model 35, resist model 37, an SMO model, and/or other models associated with and/or included in an integrated circuit manufacturing process may be an empirical model that performs the operations of the method described herein. The empirical model may predict outputs based on correlations between various inputs (e.g., one or more characteristics of a mask or wafer image, one or more characteristics of a design layout, one or more characteristics of the patterning device, one or more characteristics of the illumination used in the lithographic process such as the wavelength, etc.).

As an example, the empirical model may be a machine learning model and/or any other parameterized model. In some embodiments, the machine learning model (for example) may be and/or include mathematical equations, algorithms, plots, charts, networks (e.g., neural networks), and/or other tools and machine learning model components. For example, the machine learning model may be and/or include one or more neural networks having an input layer, an output layer, and one or more intermediate or hidden layers. In some embodiments, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In some embodiments, each individual neural unit may have a summation function that combines the values of all its inputs together. In some embodiments, each connection (or the neural unit itself) may have a threshold function such that a signal must surpass the threshold before it is allowed to propagate to other neural units. These neural network systems may be self-learning and trained, rather than explicitly programmed, and can perform significantly better in certain areas of problem solving, as compared to traditional computer programs. In some embodiments, the one or more neural networks may include multiple layers (e.g., where a signal path traverses from front layers to back layers). In some embodiments, back propagation techniques may be utilized by the neural networks, where forward stimulation is used to reset weights on the "front" neural units. In some embodiments, stimulation and inhibition for the one or more neural networks may be more free flowing, with connections interacting in a more chaotic and complex fashion. In some embodiments, the intermediate layers of the one or more neural networks include one or more convolutional layers, one or more recurrent layers, and/or other layers.

The one or more neural networks may be trained (i.e., whose parameters are determined) using a set of training data. The training data may include a set of training samples. Each sample may be a pair comprising an input object (typically a vector, which may be called a feature vector) and a desired output value (also called the supervisory signal). A training algorithm analyzes the training data and adjusts the behavior of the neural network by adjusting the parameters (e.g., weights of one or more layers) of the neural network based on the training data. For example, given a set of N training samples of the form $\{(x_1,y_1),(x_2,y_2), ..., (x_N,y_N)\}$ such that $x_i$ is the feature vector of the i-th example and $y_i$ is its supervisory signal, a training algorithm seeks a neural network $g: X \rightarrow Y$, where X is the input space and Y is the output space. A feature vector is an n-dimensional vector of numerical features that represent some object (e.g., a wafer design as in the example above). The vector space associated with these vectors is often called the feature space. After training, the neural network may be used for making predictions using new samples.

With prior machine learning models, the certainty of predictions made by the machine learning model is not clear. That is, given an input, it is not clear whether prior machine learning models generate accurate and consistent output. Machine learning models that produce accurate and consistent output are important in an integrated circuit manufacturing process. By way of a non-limiting example, when generating a mask layout from a mask layout design, uncertainties about the predictions of a machine learning model may produce uncertainties in a proposed mask layout. These uncertainties may result in questions about the ultimate functionality of a wafer, for example. More uncertainty may be introduced into the integrated circuit manufacturing process each time a machine learning model is used to model or make predictions about individual operations in the process. Until now, however, there was no method to determine variability (or uncertainty) in the output from a model.

To address these and other disadvantages of prior parameterized (e.g., machine learning) models, the present method and system include a machine learning model that uses an encoder-decoder architecture. In the middle (e.g., middle layers) of a neural network, the present machine learning model formulates a low-dimensional encoding (e.g., latent space) that encapsulates information in an input (e.g., an image, a tensor, and/or other input) to the machine learning model. Using variational inference techniques, the encoder determines a posterior probability of a latent vector, conditioned on an input. The machine learning model samples from this posterior probability, conditioned on some input. In some embodiments, sampling comprises randomly selecting numbers from a given conditional probability distribution.

The sampling may be gaussian or non-gaussian, for example. After sampling from this latent space, the machine learning model decodes the sample into the output space. The variability of the output defines the uncertainty of the machine learning model, which includes the uncertainty of model parameters (weights) as well as how parsimonious (small and descriptive) the latent space is. In some embodiments, determining the variability may comprise quantifying variability with one or more statistical operations including one or more of a mean, a moment, skewness, a standard deviation, a variance, kurtosis, covariance, and/or any other methods for quantifying variability. In some embodiments, the uncertainty of the machine learning model is related to the uncertainty of weights of parameters of the machine learning model, and the size and descriptiveness of the latent space, such that uncertainty in the weights manifests in uncertainty in the output, causing increased output variance.

This quantification of the machine learning model's output variability (again, conditioned on the input) may be used to, among other things, decide how predictive the machine learning model is. This quantification of the machine learning model's output variability may also be used to adjust (e.g., update and improve) the model. This adjustment may e.g., include adding more dimensionality to the latent space, adding more diverse training data, and/or other operations. The quantification of the machine learning model's output variability may also be used to guide the type of training data required to enhance the overall quality of the predictions of the machine learning model. It should be noted that even though a machine learning model is mentioned throughout this specification, a machine learning model is one example of a parameterized model, and the operations described herein may be applied to any parameterized model.

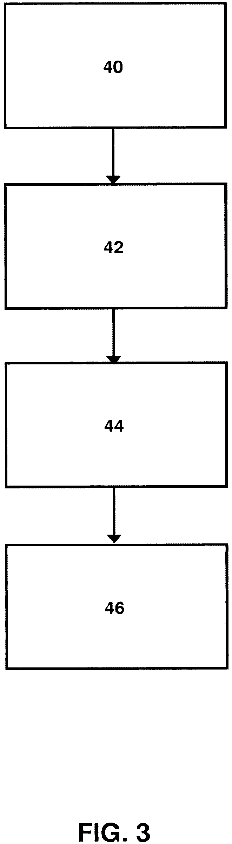

Fig. 3 illustrates a summary of operations of the present method for determining, or determining and decreasing, uncertainty in machine learning model predictions. At an operation 40, the encoder-decoder architecture of the machine learning model is trained. At an operation 42, the machine learning model is caused to predict multiple outputs from the machine learning model for a given input (e.g., x as described below). A given input may comprise, for example, an image, a clip, an encoded image, an encoded clip, data from a prior layer of the machine learning model, and/or any other data and/or object that may be encoded. At an operation 44, a variability of the predicted multiple output realizations for the given input is determined. At an operation 46, the determined variability in the predicted multiple output realizations is used to adjust the machine learning model to decrease an uncertainty of the machine learning model. In some embodiments, operation 46 is optional. In some embodiments, operation 46 comprises reporting the determined variability with or without corrective measures (e.g., reporting the determined variability in addition to and/or instead of adjusting the machine learning model to decrease an uncertainty of the machine learning model). For example, operation 46 may include outputting an indication of the determined variability. The indication may be an electronic indication (e.g., one or more signals), a visual indication (e.g., one or more graphics for display), a numerical indication (e.g., one or more numbers), and/or other indications.

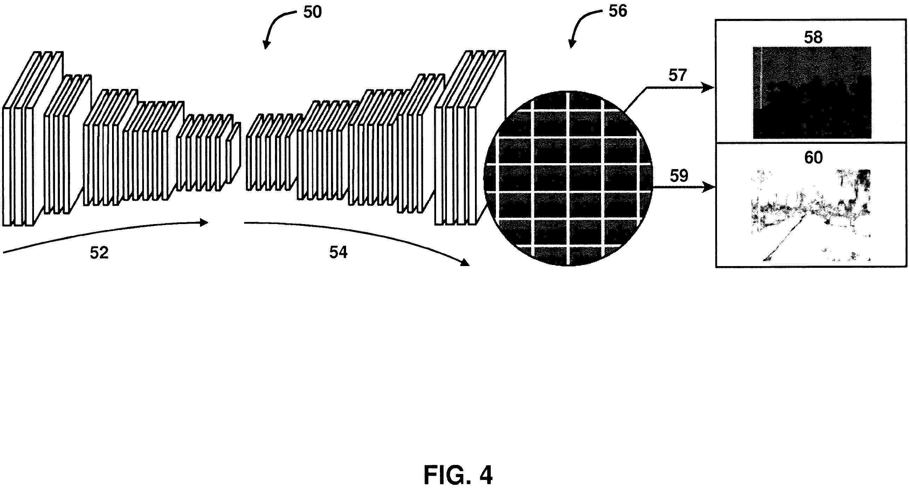

Operation 40 comprises training the encoder-decoder architecture with sampling from a latent space, which decodes into the output space. In some embodiments, the latent space comprises a low dimensional encoding. By way of a non-limiting example, Fig. 4 illustrates a convolutional encoder-decoder 50. Encoder-decoder 50 has an encoding portion 52 (an encoder) and a decoding portion 54 (a decoder). In the example shown in Fig. 4, encoder-decoder 50 may output predicted images 56, for example of a wafer as shown in Fig. 4. The image(s) 56 may have a mean 57 illustrated by segmentation image 58, a variance 59 illustrated by model uncertainty image 60, and/or other characteristics.

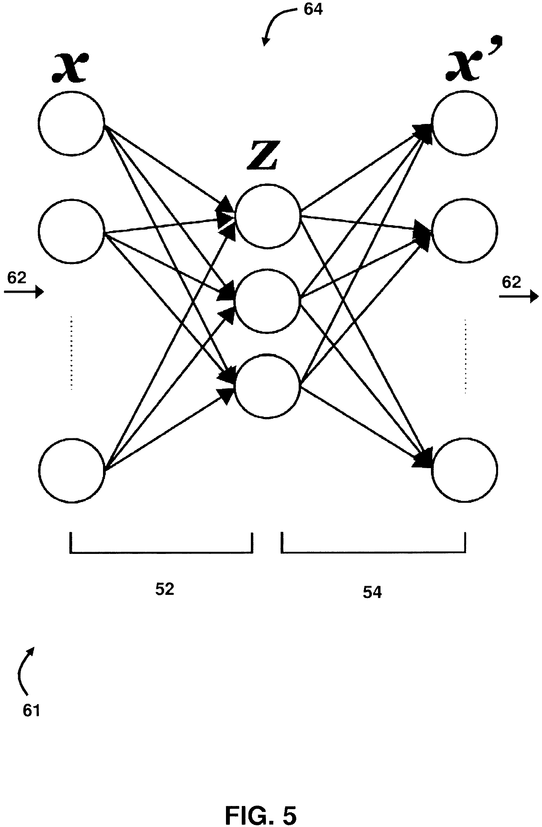

By way of another non-limiting example, Fig. 5 illustrates encoder-decoder architecture 61 within a neural network 62. Encoder-decoder architecture 61 includes encoding portion 52 and decoding portion 54. In Fig. 5, x represents encoder input (e.g., an input image and/or extracted features of the input image) and x' represents decoder output (e.g., a predicted output image and/or predicted features of an output image). In Fig. 5, z represents the latent space 64 and/or a low dimensional encoding (vector). In some embodiments, z is or is related to a latent variable. The output x' is modeled as a (possibly very complicated) function of a random vector $z \in Z$ of lower dimensionality, whose components are unobserved (latent) variables.

In some embodiments, the low dimensional encoding z represents one or more features of an input (e.g., image). The one or more features of the input may be considered key or critical features of the input. Features may be considered key or critical features of an input because they are relatively more predictive than other features of a desired output and/or have other characteristics, for example. The one or more features (dimensions) represented in the low dimensional encoding may be predetermined (e.g., by a programmer at the creation of the present machine learning model), determined by prior layers of the neural network, adjusted by a user via a user interface associated with a system described herein, and/or may be determined in by other methods. In some embodiments, a quantity of features (dimensions) represented by the low dimensional encoding may be predetermined (e.g., by the programmer at the creation of the present machine learning model), determined based on output from prior layers of the neural network, adjusted by the user via the user interface associated with a system described herein, and/or determined by other methods.

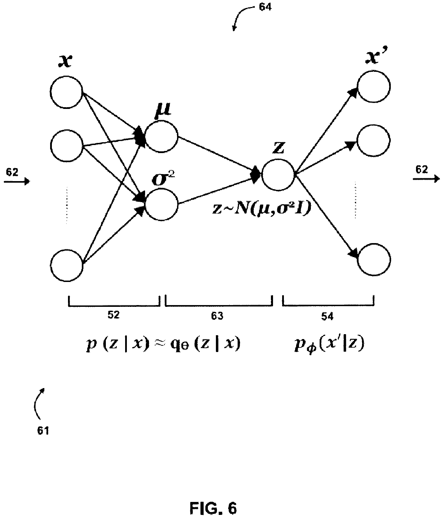

Fig. 6 illustrates the encoder-decoder architecture 61 of Fig. 5, with sampling 63 in latent space 64 (e.g., Fig. 6 may be thought of as a more detailed version of Fig. 5). As shown in Fig. 6,

$$p(z|x) \approx q_\theta(z|x) \quad [1].$$

The term p(z|x) is a conditional probability of a latent variable z, given input x. The term $q_\theta(z|x)$ is or describes weights of layers of the encoder. The term p(z|x) is or describes the theoretical probability distribution of z given x. The equation

$$z \sim N(\mu, \sigma^2 I) \quad [2]$$

is or describes the apriori distribution of the latent variable z, where $N$ denotes a normal (e.g., Gaussian) distribution, $\mu$ is the mean of the distribution, $\sigma$ is covariance, and $I$ is an identity matrix. As shown in Fig. 6, $\mu$ and $\sigma^2$, are parameters that define the probability. They are simply a proxy for the true probability that the model is trying to learn, conditioned on a given input. In some embodiments, this proxy may be much more descriptive for the task. It may be a standard probability density function, for example, or some free form probability density function that may be learned. Returning to Fig. 3, operation 42 comprises determining or otherwise learning, for a given input x, the conditional probability p(z|x) of the latent variable with the encoder (e.g., 52 shown in Fig. 4) of the encoder-decoder architecture (e.g., 61 shown in Fig. 5). Operation 42 comprises determining or otherwise learning a conditional probability p(x'|z) with a decoder (e.g., 54 shown in Fig. 5) of the encoder-decoder architecture. In some embodiments, operation 42 includes learning $\phi$ by maximizing a likelihood of generating x'$_i$ in a training set D according to the equation:

$$p(z|x) = \frac{p_\phi(x'|z)p(z)}{p(x)} \quad [3]$$

In some embodiments, the conditional probability p(z|x) is determined by the encoder using variational inference techniques. In some embodiments, the variational inference techniques comprise identifying an approximation to p(z|x) in a parametric family of distributions $q_\theta(z|x)$, where $\theta$ are parameters of the family according to the equation:

$$\min KL(p(z|x), q_\theta(z|x)) \quad [4]$$

and substituting max ELBO ($\theta$) where ELBO stands for evidence of lower bound, gives

$$ELBO(\theta) = E_{q_\theta(z|x)}[\log p_\theta(x|z)] - KL(q_\theta(z|x), p(z)) \quad [5]$$

where KL is the Kullback-Leibler divergence and is used as a measure of distance between two probability distributions, $\theta$ represents parameters of the encoding, and $\phi$ represents parameters of the decoding. The conditional probabilities $q_\theta(z|x)$ (encoder part) and $p_\phi(x'|z)$ (decoder part) are obtained by training. Operation 42 comprises sampling from the conditional probability p(z|x), and for each sample, predicting an output of the predicted multiple output realizations using the decoder of the encoder-decoder architecture based on the equations described above. Additionally: $E_{q_\theta(z|x)}[f(z)]$ denotes the expectation of f(z) where z is sampled from q(z|x).

Operation 44 comprises determining the variability of the predicted multiple output realizations for a given input (e.g., x) based on the predicted output for each sample. Given the input (e.g., x), the machine learning model determines posterior distributions $q_\theta(z|x)$ and $p_\phi(x'|q_\theta(z|x))$. Thus, operation 44 comprises determining first posterior distribution $q_\theta(z|x)$. A distance of the first posterior distribution to an origin of the latent space is inversely proportional to the uncertainty of predictions of the machine learning model (e.g., the closer a distribution is to the origin of the latent space, the more uncertain the model). Operation 44 also comprises determining second posterior distribution $p_\phi(x'|q_\theta(z|x))$. A variance of the second posterior distribution is directly related to the uncertainty of the predictions of the machine learning model (e.g., more variance of the second posterior distribution means more uncertainty). Operation 44 includes determining one or both of these posterior distributions and determining the variability based on one or both of these posterior distributions. In some embodiments,

the uncertainty of the machine learning model is related to an uncertainty of weights of parameters of the machine learning model, and a size and descriptiveness of the latent space. For example, if the latent space is low-dimensional, it won't be able to generalize over a broad set of observations. On the other hand, a large-dimensional latent space will require much more data to train the model.

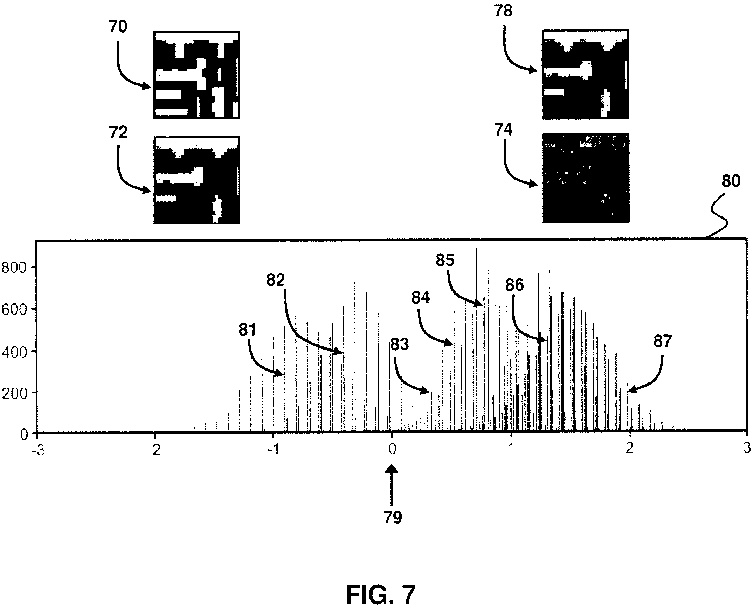

By way of a non-limiting example, Fig. 7 illustrates a mask image 70 used as input (e.g., x) for the machine learning model, a mean 72 (image) of the predicted outputs (images) from the machine learning model predicted based on mask image 70, an image 74 that illustrates variance in the predicted outputs, a scanning electron microscope (SEM) image 78 of an actual wafer pattern produced using the mask image, and a latent space 80 illustrating a posterior distribution (e.g., p(z|x)). Latent space 80 illustrates that a latent vector z had seven dimensions 81-87. Dimensions 81-87 are distributed about a center 79 of latent space 80. The distributions of the dimensions 81-87 in latent space 80 illustrate a relatively more certain model (less variance). This evidence of a relatively more certain model is corroborated by the fact that mean image 72 and SEM image 78 look similar, and there is a lack of any deep color in variance image 74, or any deep color in locations that do not correspond to areas of structure shown in SEM image 78.

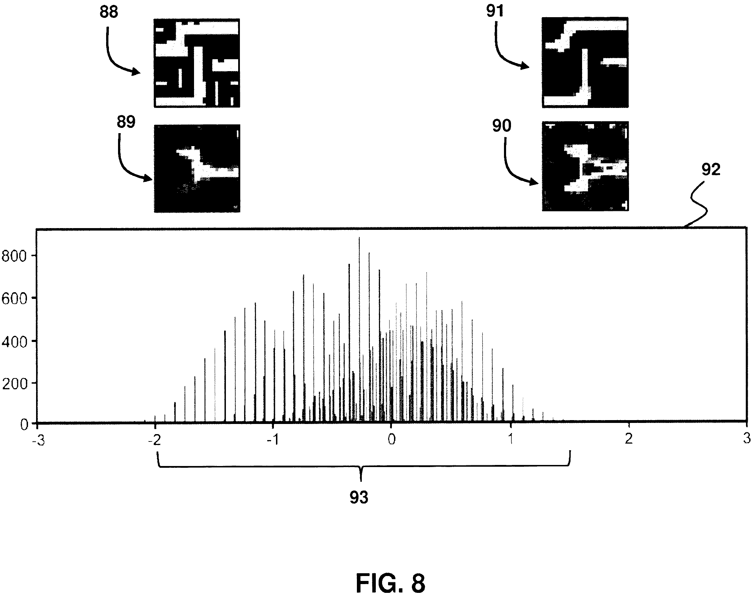

By way of a contrasting non-limiting example, FIG. 8 illustrates greater variation in machine learning model output (and more uncertainty) compared to the output shown in Fig. 7. Fig. 8 illustrates a mask image 88 used as input (e.g., x) for the machine learning model, a mean 89 of the predicted outputs from the machine learning model predicted based on mask image 88, an image 90 that illustrates variance in the predicted outputs, an SEM image 91 of an actual mask produced using the mask image, and a latent space 92 illustrating a posterior distribution. Latent space 92 illustrates that a latent vector z again had several dimensions 93. The distributions of the dimensions 93 in latent space 92 now illustrate a relatively more uncertain model. The distributions of dimensions 93 in latent space 92 are more concentrated at the origin (narrower) leading to a larger uncertainty in the output (e.g., as described herein, the method comprises determining a first posterior distribution $q\_\theta(z|x)$, wherein a distance of the first posterior distribution to an origin of the latent space is inversely proportional to the uncertainty of the machine learning model). This evidence of a relatively uncertain model is corroborated by the fact that mean image 89 and SEM image 91 look very different, and there is an abundance of deep color in variance image 90 in locations where no corresponding structure is visible in SEM image 91.

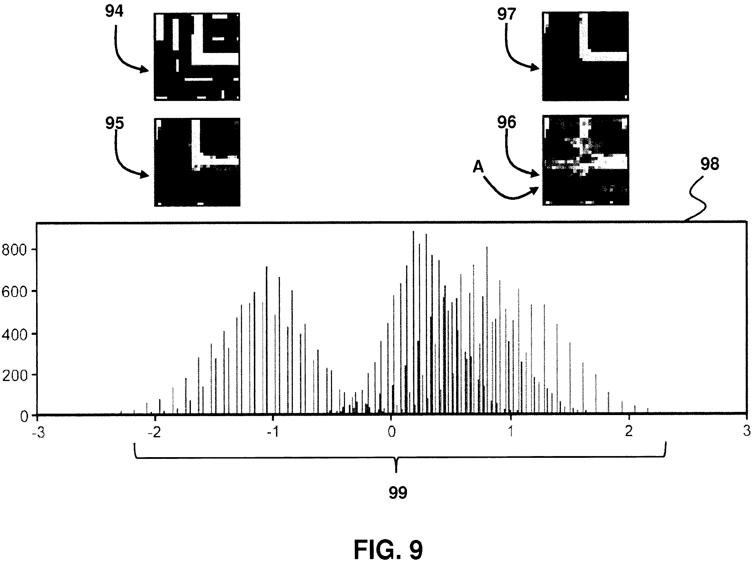

By way of a third non-limiting example, Fig. 9 illustrates a mask image 94 used as input (e.g., x) for the machine learning model, a mean 95 of the predicted outputs from the machine learning model predicted based on mask image 94, an image 96 that illustrates variance in the predicted outputs, an SEM image 97 of an actual mask produced using mask image 94, and a latent space 98 illustrating several dimensions 99 of a latent vector z. The images 94-97 and the distributions of the dimensions 99 in latent space 98 now illustrate a model with more variation than that shown in Fig. 7, but less that what is shown in Fig. 8. For example, mean image 95 looks similar to SEM image 97, but variance image 96 shows more intense color in an area A, where no corresponding structure is visible in SEM image 97.

Returning to Fig. 3, in some embodiments, operation 46 is configured such that using the determined variability in the predicted multiple output realizations to adjust the machine learning model to decrease the uncertainty of the machine learning model comprises increasing a training set size and/or adding to a dimensionality of the latent space. In some embodiments, increasing a training set size and/or adding to a dimensionality of the latent space comprises using more diverse images, more diverse data, and additional clips relative to prior training material as input to train the machine learning model; and using more dimensions for encoding vectors, and more encoding layers in the machine learning model, and/or other training set and/or dimensionality increase operations. In some embodiments, operation 46 is configured such that using the determined variability in the predicted multiple output realizations to adjust the machine learning model to decrease the uncertainty of the machine learning model comprises adding additional dimensionality to the latent space. In some embodiments, operation 46 is configured such that using the determined variability in the predicted multiple output realizations to adjust the machine learning model to decrease the uncertainty of the machine learning model comprises training the machine learning model with additional and more diverse sampling from the latent space relative to prior sampling from the latent space and/or prior training data used to train the model.

By way of non-limiting examples, in some embodiments, operation 46 comprises using the determined variability in the predicted multiple output realizations to adjust the machine learning model to decrease the uncertainty of the machine learning model for predicting mask geometry in a semiconductor manufacturing process. Looking back at Fig. 7-9, if the variability (e.g., as shown in the variability images) of the output (e.g., the predicted mean images) from the machine learning model is high as shown in Fig. 8, the training set size may be increased, and/or the dimensionality of the latent space may be increased as described above. However, if the variability of the output from the machine learning model is low as shown in Fig. 7, little to no adjustment may be needed.

In some embodiments, the present method may be used to identify possible flaws in the model without adjusting the model and, for example, use a different (e.g. physical) model to re-determine uncertainty for a specific clip (or image, data, or any other input). In this example, the uncertainty may be used to, for example, better study the physics (e.g., resist chemistry, the effect of various pattern shapes, materials, etc.) of a given process.

Other examples, related to several different aspects of an integrated circuit fabrication process, and/or other processes, are contemplated. For example, in some embodiments, operation 46 comprises using the determined variability in the predicted multiple output realizations to adjust the machine learning model to decrease the uncertainty of the machine learning model for predicting wafer geometry as part of a semiconductor manufacturing process. In some embodiments, operation 46 comprises using the determined variability in the predicted multiple output realizations to adjust the machine learning model to decrease the uncertainty of the machine learning model for generating a predicted overlay as part of a semiconductor manufacturing process.

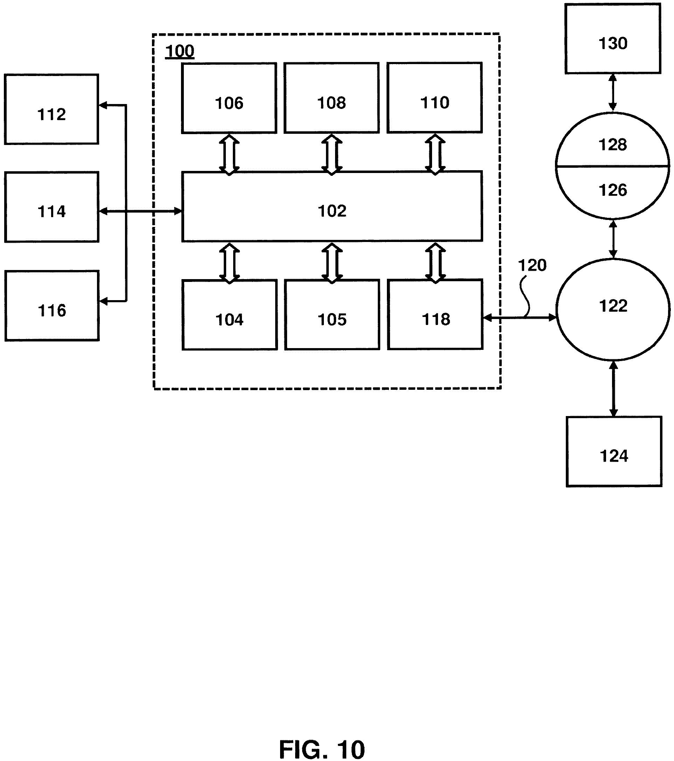

Fig. 10 is a block diagram that illustrates a computer system 100 that can assist in implementing the methods, flows, or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

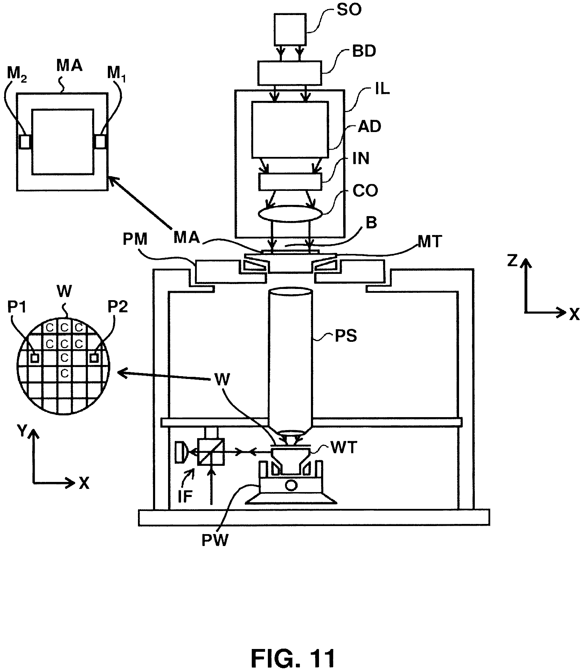

Fig. 11 schematically depicts an exemplary lithographic projection apparatus that may be utilized in conjunction with the techniques described herein. The apparatus comprises:

- an illumination system IL, to condition a beam B of radiation. In this particular case, the illumination system also comprises a radiation source SO;
- a first object table (e.g., patterning device table) MT provided with a patterning device holder to hold a patterning device MA (e.g., a reticle), and connected to a first positioner to accurately position the patterning device with respect to item PS;
- a second object table (substrate table) WT provided with a substrate holder to hold a substrate W (e.g., a resist-coated silicon wafer), and connected to a second positioner to accurately position the substrate with respect to item PS; and
- a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive patterning device). However, in general, it may also be of a reflective type, for example (with a reflective patterning device). The apparatus may employ a different kind of patterning device relative to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as $\sigma$-outer and $\alpha$-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Fig. 10 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or $F_2$ lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 11. However, in the case of a stepper (as opposed to a step-and-scan tool) the patterning device table MT may just be connected to a short stroke actuator, or may be fixed.

The depicted tool can be used in two different modes:

- In step mode, the patterning device table MT is kept essentially stationary, and an entire patterning device image is projected in one go (i.e., a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

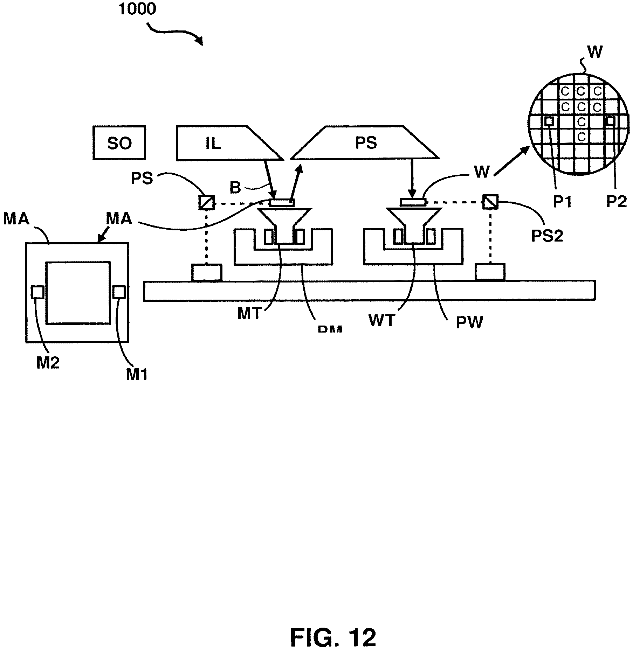

Fig. 12 schematically depicts another exemplary lithographic projection apparatus 1000 that can be utilized in conjunction with the techniques described herein.

The lithographic projection apparatus 1000 comprises:

- a source collector module SO
- an illumination system (illuminator) IL configured to condition a radiation beam B (e.g. EUV radiation).
- a support structure (e.g. a patterning device table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As depicted in Fig. 12, the apparatus 1000 is of a reflective type (e.g. employing a reflective patterning device). It is to be noted that because most materials are absorptive within the EUV wavelength range, the patterning device may have multilayer reflectors comprising, for example, a multi-stack of Molybdenum and Silicon. In one example, the multi-stack reflector has 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

The illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Fig. 12, for providing the laser beam exciting the fuel. The resulting plasma emits output radiation, e.g., EUV radiation, which is collected using a radiation collector, disposed in the source collector module. The laser and the source collector module may be separate entities, for example when a $CO_2$ laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases the source may be an integral part of the source collector module, for example when the source is a discharge produced plasma EUV generator, often termed as a DPP source. In an embodiment, a DUV laser source may be used.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus 1000 could be used in at least one of the following modes:

In step mode, the support structure (e.g. patterning device table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

In scan mode, the support structure (e.g. patterning device table) MT and the substrate table WT are scanned synchronously while a pattern imparted to the radiation beam is projected onto a target portion C (i.e. a single dynamic exposure). The velocity and direction of the substrate table WT relative to the support structure (e.g. patterning device table) MT may be determined by the (de-)magnification and image reversal characteristics of the projection system PS.

In another mode, the support structure (e.g. patterning device table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

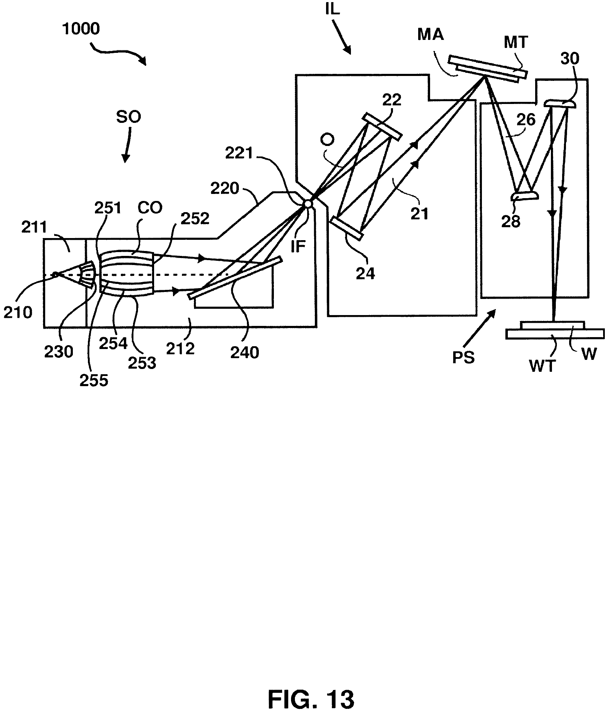

Fig. 13 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be 1- 6 additional reflective elements present in the projection system PS than shown in Fig. 13.

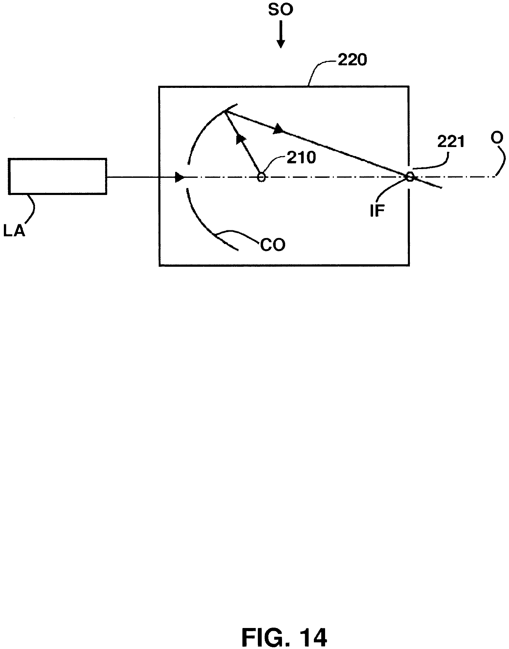

Collector optic CO, as illustrated in Fig. 14, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

Alternatively, the source collector module SO may be part of an LPP radiation system as shown in Fig. 14. A laser LA is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The embodiments may further be described using the following clauses:

    1. A method for quantifying uncertainty in machine learning model predictions, the method comprising:

        causing a machine learning model to predict multiple output realizations from the machine learning model for a given input;
        determining a variability of the predicted multiple output realizations for the given input; and
        using the determined variability in the predicted multiple output realizations to quantify uncertainty in the predicted multiple output realizations from the machine learning model.

    2. The method of clause 1, wherein causing the machine learning model to predict multiple output realizations comprises sampling from a conditional probability conditioned on the given input.

3. The method of any of clauses 1 to 2, wherein a given input comprises one or more of an image, a clip, an encoded image, an encoded clip, or data from a prior layer of the machine learning model.

4. The method of any of clauses 1 to 3, further comprising using the determined variability in the predicted multiple output realizations and/or the quantified uncertainty to adjust the machine learning model to decrease the uncertainty of the machine learning model by making the machine learning model more descriptive or including more diverse training data.

5. The method of any of clauses 1 to 4, wherein the machine learning model comprises encoder-decoder architecture.

6. The method of clause 5, wherein the encoder-decoder architecture comprises variational encoder-decoder architecture, the method further comprising training the variational encoder-decoder architecture with a probabilistic latent space, which generates realizations in an output space.

7. The method of clause 6, wherein the latent space comprises a low dimensional encoding.

8. The method of clause 7, further comprising determining, for the given input, a conditional probability of a latent variable using an encoder part of the encoder-decoder architecture.

9. The method of clause 8, further comprising determining a conditional probability using a decoder part of the encoder-decoder architecture.

10. The method of clause 9, further comprising sampling from the conditional probability of the latent variable determined using the encoder part of the encoder-decoder architecture, and for each sample, predicting an output using the decoder part of the encoder-decoder architecture.

11. The method of clause 10, wherein sampling comprises randomly selecting numbers from a given conditional probability distribution, wherein the sampling is gaussian or non-gaussian.

12. The method of clause 10, further comprising determining the variability of the predicted multiple output realizations for the given input based on the predicted output for each sample in the latent space.

13. The method of clause 12, wherein determining the variability comprises quantifying variability with one or more statistical operations including one or more of a mean, a moment, skewness, a standard deviation, a variance, kurtosis, or covariance.

14. The method of any of clauses 8 to 13, wherein the conditional probability of the latent variable determined using the encoder part of the encoder-decoder architecture is determined by the encoder part using variational inference techniques.

15. The method of clause 14, wherein the variational inference techniques comprise identifying an approximation to the conditional probability of the latent variable using the encoder part of the encoder-decoder architecture in a parametric family of distributions.

16. The method of clause 15, wherein a parametric family of distributions comprises a parameterized distribution, wherein family refers to a type or shape of the distribution, or combinations of distributions.

17. The method of any of clauses 1 to 16, further comprising determining a first posterior distribution, wherein a distance of the first posterior distribution to an origin of the latent space is inversely proportional to the uncertainty of the machine learning model.

18. The method of any of clauses 1 to 17, further comprising determining a second posterior distribution, wherein a variance of the second posterior distribution is directly related to the uncertainty of the machine learning model.

19. The method of clause 18, wherein determining the second posterior distribution comprises directly sampling the latent space.

20. The method of clause 18, wherein the second posterior distribution is learned.

21. The method of any of clauses 1 to 20, wherein the uncertainty of the machine learning model is related to an uncertainty of weights of parameters of the machine learning model, and a size and descriptiveness of the latent space.

22. The method of clause 21, wherein the uncertainty of the machine learning model is related to the uncertainty of weights of parameters of the machine learning model, and the size and descriptiveness of the latent space, such that uncertainty in the weights manifests in uncertainty in the output, causing increased output variance.

23. The method of any of clauses 2 to 22, wherein using the determined variability in the predicted multiple output realizations to adjust the machine learning model to decrease the uncertainty of the machine learning model comprises increasing a training set size and/or adding to a dimensionality of the latent space.

24. The method of clause 23, wherein increasing a training set size and/or adding to a dimensionality of the latent space comprises using more diverse images, more diverse data, and additional clips relative to prior training material as input to train the machine learning model; and using more dimensions for encoding vectors, and more encoding layers in the machine learning model.

25. The method of any of clauses 2 to 24, wherein using the determined variability in the predicted multiple output realizations to adjust the machine learning model to decrease the uncertainty of the machine learning model comprises adding additional dimensionality to the latent space.

26. The method of any of clauses 2 to 25, wherein using the determined variability in the predicted multiple output realizations to adjust the machine learning model to decrease the uncertainty of the machine learning model comprises training the machine learning model with additional and more diverse training samples.

27. The method of clause 26, wherein the additional and more diverse training samples comprise more diverse images, more diverse data, and additional clips relative to prior training material.

28. The method of any of clauses 2 to 27, further comprising using the determined variability in the predicted multiple output realizations to adjust the machine learning model to decrease the uncertainty of the machine learning model for predicting wafer geometry as part of a semiconductor manufacturing process.

29. The method of clause 28, wherein using the determined variability in the predicted multiple output realizations to adjust the machine learning model to decrease the uncertainty of the machine learning model for predicting wafer geometry as part of a semiconductor manufacturing process comprises using more diverse images, more diverse data, and additional clips relative to prior training material as input to train the machine learning model; and using more dimensions for encoding vectors, and more encoding layers in the machine learning model, the more diverse images, more diverse data, additional clips, more dimensions, and more encoding layers determined based on the determined variability.

30. The method of any of clauses 2 to 29, further comprising using the determined variability in the predicted multiple output realizations to adjust the machine learning model to decrease the uncertainty of the machine learning model for generating a predicted overlay as part of a semiconductor manufacturing process.

31. The method of clause 30, wherein using the determined variability in the predicted multiple output realizations to adjust the machine learning model to decrease the uncertainty of the machine learning model for generating a predicted overlay as part of a semiconductor manufacturing process comprises using more diverse images, more diverse data, and additional clips relative to prior training material as input to train the machine learning model; and using more dimensions for encoding vectors, and more encoding layers in the machine learning model, the more diverse images, more diverse data, additional clips, more dimensions, and more encoding layers determined based on the determined variability.

32. A method for quantifying uncertainty in parameterized model predictions, the method comprising:

causing a parameterized model to predict multiple output realizations from the parameterized model for a given input;
determining a variability of the predicted multiple output realizations for the given input; and
using the determined variability in the predicted multiple output realizations to quantify uncertainty in the predicted multiple output realizations from the parameterized model.

33. The method of clause 32, wherein the parameterized model is a machine learning model.

34. A computer program product comprising a non-transitory computer readable medium having instructions recorded thereon, the instructions when executed by a computer implementing the method of any of clauses 1 to 33.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The descriptions above are intended to be illustrative, not limiting. Thus, it will be apparent to one skilled in the art that modifications may be made as described without departing from the scope of the claims set out below.

**Claims**

1. A method for quantifying uncertainty in machine learning model predictions, the method comprising:

causing a machine learning model to predict multiple output realizations from the machine learning model for a given input;
determining a variability of the predicted multiple output realizations for the given input; and
using the determined variability in the predicted multiple output realizations to quantify uncertainty in the predicted multiple output realizations from the machine learning model.

2. The method of claim 1, wherein causing the machine learning model to predict multiple output realizations comprises sampling from a conditional probability conditioned on the given input.

3. The method of claim 1, wherein a given input comprises one or more of an image, a clip, an encoded image, an encoded clip, or data from a prior layer of the machine learning model.

4. The method of claim 1, further comprising using the determined variability in the predicted multiple output realizations and/or the quantified uncertainty to adjust the machine learning model to decrease the uncertainty of the machine learning model by making the machine learning model more descriptive or including more diverse training data.

5. The method of claim 1, wherein the machine learning model comprises encoder-decoder architecture.

6. The method of claim 5, wherein the encoder-decoder architecture comprises variational encoder-decoder architecture, the method further comprising training the variational encoder-decoder architecture with a probabilistic latent space, which generates realizations in an output space, wherein the latent space comprises a low dimensional encoding.

7. The method of claim 6, further comprising determining, for the given input, a conditional probability of a latent variable using an encoder part of the encoder-decoder architecture.

8. The method of claim 7, further comprising determining a conditional probability using a decoder part of the encoder-decoder architecture.

9. The method of claim 8, further comprising sampling from the conditional probability of the latent variable determined using the encoder part of the encoder-decoder architecture, and for each sample, predicting an output using the decoder part of the encoder-decoder architecture, wherein sampling comprises randomly selecting numbers from a given conditional probability distribution, and wherein the sampling is gaussian or non-gaussian.

10. The method of claim 9, further comprising determining the variability of the predicted multiple output realizations for the given input based on the predicted output for each sample in the latent space.

11. The method of claim 7, wherein the conditional probability of the latent variable determined using the encoder part of the encoder-decoder architecture is determined by the encoder part using variational inference techniques.

12. The method of claim 1, further comprising determining a first posterior distribution, wherein a distance of the first posterior distribution to an origin of the latent space is inversely proportional to the uncertainty of the machine learning model.

13. The method of claim 2, wherein using the determined variability in the predicted multiple output realizations to adjust the machine learning model to decrease the uncertainty of the machine learning model comprises increasing a training set size and/or adding to a dimensionality of the latent space.

14. The method of claim 2, further comprising using the determined variability in the predicted multiple output realizations to adjust the machine learning model to decrease the uncertainty of the machine learning model for predicting wafer geometry as part of a semiconductor manufacturing process.

15. A computer program product comprising a non-transitory computer readable medium having instructions recorded thereon, the instructions when executed by a computer implementing the method of any of claims 1 to 14.

**FIG. 1**

FIG. 2

FIG. 3

FIG. 4

FIG. 5

**FIG. 6**

**FIG. 7**

**FIG. 8**

**FIG. 9**

**FIG. 10**

**FIG. 11**

**FIG. 12**

**FIG. 13**

SO

220

210

221

O

LA

IF

CO

**FIG. 14**

Europäisches
Patentamt

European
Patent Office

Office européen
des brevets

# EUROPEAN SEARCH REPORT

Application Number

EP 18 20 9496

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | EP 3 343 456 A1 (DENSO IT LAB INC [JP])<br>4 July 2018 (2018-07-04)<br>* abstract *<br>* paragraph [0016] - paragraph [0065] *<br>* figures 1B, 8A * | 1,2,12,<br>15<br>14 | INV.<br>G06N3/04<br>G06N3/08<br>G03F1/36<br>G03F7/20 |
| X | MADIREDDY SANDEEP ET AL: "Modeling I/O<br>Performance Variability Using Conditional<br>Variational Autoencoders",<br>2018 IEEE INTERNATIONAL CONFERENCE ON<br>CLUSTER COMPUTING (CLUSTER), IEEE,<br>10 September 2018 (2018-09-10), pages<br>109-113, XP033433939,<br>DOI: 10.1109/CLUSTER.2018.00022<br>[retrieved on 2018-10-29]<br>* abstract *<br>* page 110, right-hand column, line 1 -<br>page 111, left-hand column, line 15 * | 1,2,<br>5-12,15 | |
| X | EP 3 407 267 A1 (HITACHI LTD [JP])<br>28 November 2018 (2018-11-28)<br>* abstract *<br>* paragraph [0015] - paragraph [0038] *<br>* figures 1, 4 * | 1,2,4,<br>12,13,15 | TECHNICAL FIELDS<br>SEARCHED (IPC)<br><br>G06N<br>G03F |
| X | REMUS POP ET AL: "Deep Ensemble Bayesian<br>Active Learning : Addressing the Mode<br>Collapse issue in Monte Carlo dropout via<br>Ensembles",<br>ARXIV.ORG, CORNELL UNIVERSITY LIBRARY, 201<br>OLIN LIBRARY CORNELL UNIVERSITY ITHACA, NY<br>14853,<br>9 November 2018 (2018-11-09), XP081048212,<br>* abstract *<br>* page 3, line 5 - page 6, line 36 * | 2,4,12,<br>13,15 | |

-/--

The present search report has been drawn up for all claims

| Place of search | Date of completion of the search | Examiner |
|---|---|---|
| The Hague | 21 May 2019 | Mandato, Davide |

EPO FORM 1503 03.82 (P04C01)

Europäisches
Patentamt

European
Patent Office

Office européen
des brevets

**EUROPEAN SEARCH REPORT**

Application Number

EP 18 20 9496

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2018/215188 A1 (ASML NETHERLANDS BV [NL]) 29 November 2018 (2018-11-29) | 14 | |
| A | * abstract *<br>* figures 4A-4D * | 1-13,15 | |
| | ----- | | |

TECHNICAL FIELDS
SEARCHED      (IPC)

The present search report has been drawn up for all claims

| Place of search | Date of completion of the search | Examiner |
|---|---|---|
| The Hague | 21 May 2019 | Mandato, Davide |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 20 9496

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2019

| Patent document cited in search report | | | Publication date | Patent family member(s) | | | Publication date |
|---|---|---|---|---|---|---|---|
| EP | 3343456 | A1 | 04-07-2018 | CN | 108241888 | A | 03-07-2018 |
| | | | | EP | 3343456 | A1 | 04-07-2018 |
| | | | | JP | 2018106463 | A | 05-07-2018 |
| | | | | US | 2018181865 | A1 | 28-06-2018 |
| EP | 3407267 | A1 | 28-11-2018 | EP | 3407267 | A1 | 28-11-2018 |
| | | | | JP | 6507279 | B2 | 24-04-2019 |
| | | | | JP | 2018200677 | A | 20-12-2018 |
| | | | | US | 2018341876 | A1 | 29-11-2018 |
| WO | 2018215188 | A1 | 29-11-2018 | TW | 201901285 | A | 01-01-2019 |
| | | | | WO | 2018215188 | A1 | 29-11-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6046792 A
- US 5229872 A
- US 20090157630 A
- US 20080301620 A
- US 20070050749 A
- US 20070031745 A
- US 20080309897 A
- US 20100162197 A
- US 20100180251 A
- US 7587704 B
- US 8200468 B